# EUROPEAN PATENT APPLICATION

(11) **EP 4 653 756 A1**
(43) Date of publication of application: **26.11.2025**
(21) Application number: 24801065.4
(22) Date of filing: 07.06.2024
(51) Int. Cl.: F21K 9/69, F21V 5/04, F21K 9/68, F21V 7/04, F21K 9/237, F21V 23/00, F21S 2/00, H10H 20/855, F21Y 115/10

(54) **ULTRA-WIDE ANGLE LED MODULE**

(30) Priority: 11.04.2024 KR 20240048454
(71) Applicant: Interone Co., Ltd, Yangju-si, Gyeonggi-do 11460 (KR)
(72) Inventor: NA, Jeong Hun, Yangju-si, Gyeonggi-do 11460 (KR)
(74) Representative: Krauns, Christian
(86) International application number: PCT/KR2024/095875
(87) International publication number: WO 2025/216393

(57) **Abstract**

The present invention provides an ultra wide angle LED module including: a circuit board including at least one LED; a lower case having an upper side opened to be installed therein with a circuit board; and an upper case coupled to the upper side of the lower case and having a refractive lens for refracting light emitted from the LED, wherein the refractive lens includes: a light-collecting groove for accommodating the LED inside to refract the light primarily emitted from the LED, and a first diffuse-reflecting portion formed on a surface opposite to the circuit board to have a plurality of concave grooves to secondarily refract the light emitted from the LED, and the first diffuse-reflecting portion is arranged to contact the circuit board.

## Description

### BACKGROUND OF THE INVENTION

### 1. Field of the Invention

The present invention relates to an ultra wide angle LED module, and more particularly, to an ultra wide angle LED module for diffusely reflecting light to irradiate the light forwardly and even laterally and rearwardly.

### 2. Description of the Related Art

In general, a light-emitting diode (LED) refers to a light-emitting diode device, and refers to a device for utilizing a phenomenon of light being generated when a current flows through a PN junction of compound semiconductors such as GaP and GaAs.

The LED has a wide range of applications, and accordingly, has been applied to various products. For example, LED modules are used as lighting for a channel signboard.

In other words, the LED module applied to the channel signboard is installed inside the channel signboard cut and curved in various shapes to express three-dimensional characters and provided at a front thereof with an acrylic plate through which light is allowed to pass. A plurality of LED modules are installed at regular spacings in the channel signboard so as to be used as lighting.

More specifically, because an LED used in an LED module applied to a channel signboard basically has a diffusion angle of 125 degrees, multiple LEDs are installed considering the diffusion angle.

When an installation spacing between the LED modules applied to the channel signboard is too far apart, shadows are generated in a portion in which light does not reach, thereby causing the portion appear darker. In contrast, when the installation spacing between the LED modules is narrowed, amounts of LED modules required for the installation increase, and accordingly installation costs may increase.

Accordingly, the LED modules are installed in multiple positions at appropriate spacings for taking into account the diffusion angle.

However, since the existing LED modules have a limited diffusion angle, the LED modules disposed at the outermost part of the channel signboard may fail to handle a shadow generated on a side of the signboard.

### (Documents of Related Art)

### (Patent Documents)

Korean Patent Registration No. 10-1432169 (Registered on August 13, 2014)

### SUMMARY OF THE INVENTION

An object of the present invention is to develop an ultra wide angle LED module for diffusely reflecting light emitted from an LED to irradiate the LED light forwardly and even laterally and rearwardly.

The technical problem to be solved by the present invention is not limited to the above-mentioned object, and a person having ordinary skill in the art may apparently understand other objects not mentioned herein based on the following descriptions.

The above-mentioned object is achieved by an ultra wide angle LED module according to one embodiment of the present invention including: a circuit board including at least one LED; a lower case having an upper side opened to be installed therein with a circuit board; and an upper case coupled to the upper side of the lower case and having a refractive lens for refracting light emitted from the LED, wherein the refractive lens includes: a light-collecting groove for accommodating the LED inside to refract the light primarily emitted from the LED; and a first diffuse-reflecting portion formed on a surface opposite to the circuit board to have a plurality of concave grooves to secondarily refract the light emitted from the LED, and the first diffuse-reflecting portion is arranged to contact the circuit board.

Substrate members arranged on the circuit board may be positioned on a surface of the upper case facing the circuit board.

The concave groove may have an opening formed in a rectangular shape, and a plurality of concave grooves may be arranged so that their respective side surfaces come into contact with each other.

The upper case may have a lower surface formed with a second diffuse-reflecting portion having a plurality of concave grooves to refract the light emitted from the LED.

The second diffuse-reflecting portion may extend continuously from the first diffuse-reflecting portion.

In addition, the above object may be achieved by an ultra wide angle LED module according to another embodiment of the present invention including: a circuit board including at least one LED; a lower case having an upper side opened to be installed therein with a circuit board; and an upper case coupled to the upper side of the lower case and having a refractive lens for refracting light emitted from the LED, wherein the refractive lens includes: a light-collecting groove for accommodating the LED inside to refract primarily the light emitted from the LED; and a first diffuse-reflecting portion formed on a surface opposite to the circuit board to have a plurality of concave grooves to secondarily refract the light emitted from the LED, and the first diffuse-reflecting portion is arranged to be spaced apart from the circuit board by a predetermined distance or more.

The refractive lens may further include a protrusion formed in a direction of the circuit board to separate the distance between the first diffuse-reflecting portion and the circuit board.

The protrusion may be formed therein with a hollow to communicate with the light-collecting groove and accommodate the LED inside.

The concave groove may have an opening formed in a rectangular shape, and a plurality of concave grooves may be arranged so that respective side surfaces come into contact with each other.

The upper case may have a lower surface formed with a second diffuse-reflecting portion having a plurality of concave grooves to refract the light emitted from the LED.

The second diffuse-reflecting portion may extend continuously from the first diffuse-reflecting portion.

In the ultra wide angle LED module according to one embodiment of the present invention, LED light irradiated in one direction is diffusedly reflected, thereby reaching even lateral and rear sides of the LED module, so that light efficiency can be improved.

### BRIEF DESCRIPTION OF THE DRAWINGS

FIG. 1 is a schematic view showing an ultra wide angle LED module according to one embodiment of the present invention.
FIG. 2 is an exploded perspective view of the ultra wide angle LED module according to the one embodiment of the present invention.
FIG. 3 is a sectional view of an upper case and a circuit board included in the ultra wide angle LED module of FIG. 1.
FIG. 4 is a bottom view of the upper case shown in FIG. 3.
FIG. 5 is a bottom view of upper cases included in an ultra wide angle LED module according to another embodiment of the present invention.
FIG. 6 is a sectional view of an upper case and a circuit board included in an ultra wide angle LED module according to another embodiment of the present invention.
FIG. 7 is a bottom view of the upper case shown in FIG. 6.
FIG. 8 is a view showing an operating status of a general LED module.
FIG. 9 is a view showing an operating state of the ultra wide angle LED module according to the one embodiment of the present invention.

### DETAILED DESCRIPTION OF THE INVENTION

The embodiments described in this specification and the configurations shown in the drawings are merely preferred examples according to the present invention, and there may be various modifications that may replace the embodiments and the drawings of this specification at the time of filing of the present application.

The same reference numbers or symbols presented in each drawing of the present specification denote parts or components serving substantially the same function. Shapes, sizes and the like of the components in the drawings may be exaggerated for clearer description.

The terms used in this specification are merely used to describe the embodiments, and are not intended to limit and/or restrict the disclosed invention. The singular expression includes a plural expression unless the context clearly means otherwise. In this specification, it will be understood that the term such as "include" and "have" is intended to designate the presence of feature, number, step, operation, element, component, or a combination thereof recited in the specification, which does not preclude the possibility of the presence or addition of one or more other features, numbers, steps, operations, components, parts or combinations thereof.
The terms including ordinal numbers, such as "first," or "second", used in this specification may be used to describe various components, however, the components are not limited by the above terms. The terms are used only for the purpose of distinguishing one component from another component. For example, the first component may be referred to as the second component without departing from the scope of the present invention, and similarly, the second component may also be referred to as the first component.

Hereinafter, an ultra wide angle LED module according to one embodiment of the present invention will be described with reference to the accompanying drawings.

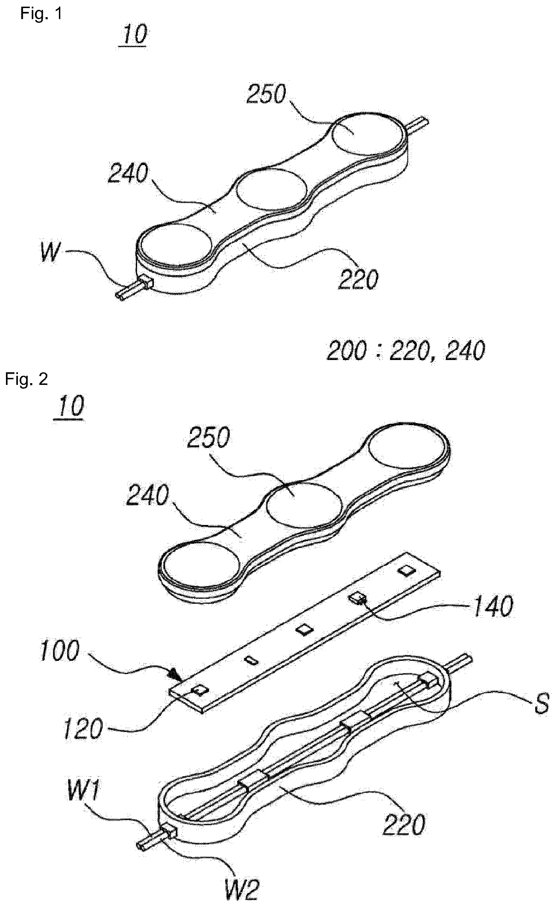

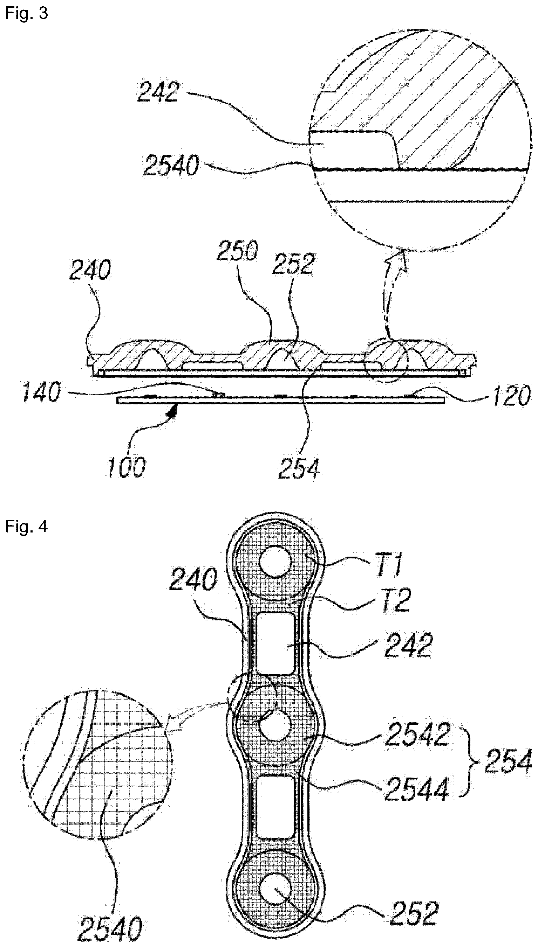

FIG. 1 is a schematic view showing an ultra wide angle LED module according to one embodiment of the present invention. FIG. 2 is an exploded perspective view of the ultra wide angle LED module according to the one embodiment of the present invention. FIG. 3 is a sectional view of an upper case and a circuit board included in the ultra wide angle LED module of FIG. 1. FIG. 4 is a bottom view of the upper case shown in FIG. 3.

Referring to FIGS. 1 to 4, the ultra wide angle LED module 10 may include a circuit board 100 and an LED module case 200.

The circuit board 100 may be installed inside the LED module case 200. The circuit board 100 is accommodated inside the LED module case 200. An LED 120 and a substrate member 140 are installed on the circuit board 100.

A plurality of LEDs 120 may be provided. The LEDs 120 may be disposed only on the same side of the circuit board 100. For example, the LEDs 120 may be arranged at the same intervals on the circuit board 100.

The substrate member 140 is installed on the circuit board 100. The substrate member 140 is installed on the same surface as the LEDs 120 to connect the circuit board 100 to the LEDs 120. The substrate member 140 includes parts such as a condenser and a resistor.

The LED module case 200 defines an internal space S in which the circuit board 100 is installed. The LED module case 200 includes a lower case 220 and an upper case 240.

The lower case 220 has one side opened to define the internal space S in which the circuit board 100 is accommodated. For example, an upper side of the lower case 220 is opened and the circuit board 100 is inserted and installed thereto.

The lower case 220 has a bottom surface in which a wire W may be buried. The wire W may be composed of a pair of a (+) wire W1 and a (-) wire W2. The wire W is electrically connected to the circuit board 100. The lower case 220 may have both ends formed with holes (not shown) through which the wire W passes.

The upper case 240 is coupled to the lower case 220. The upper case 240 is coupled to the upper side of the lower case 220 to seal the internal space S. The upper case 240 may be formed in a shape corresponding to the lower case 220. The upper case 240 is formed of a transparent material for allowing light to pass through. For example, the upper case 240 may be formed of glass or synthetic resin. The upper case 240 has a refractive lens 250.

The refractive lens 250 is coupled to the upper case 240. The refractive lens 250 may be formed integrally with the upper case 240. The refractive lens 250 may be formed of the same material as the upper case 240.

The refractive lens 250 refracts light irradiated from the LEDs 120. For example, the refractive lens 250 may increase a diffusion angle of light by diffusing the light irradiated from the LEDs 120 over a wide range. The refractive lens 250 may be provided in a number corresponding to the number of LEDs 120. The refractive lens 250 may be formed at a position that overlaps with the LED 120 in a vertical direction.

As shown in FIG. 3, the refractive lens 250 may have an upper side formed in a convex shape and a lower side formed in a concave shape. The refractive lens 250 includes a light-collecting groove 252 and a diffuse-reflecting portion 254.

The light-collecting groove 252 is formed on the lower side of the refractive lens 250 to primarily refract the light irradiated from the LED 120. The light-collecting groove 252 may be formed in a concave groove shape. The light-collecting groove 252 may collect the light irradiated from the LED 120. The light-collecting groove 252 may increase an irradiation distance of the light by directing the light irradiated from the LED 120. The light-collecting groove 252 may accommodates the LED 120 inside. The light-collecting groove 252 may have an opening arranged to come into contact with the circuit board 100 to cover the entire LED 120. The shape of the light collecting groove 252 will be understood as a shape for allowing light to refract over a wider range than the diffusion angle of the light irradiated from the LED 120, but the present invention is not limited thereto.

The diffuse-reflecting portion 254 is formed on a lower surface of the upper case 240. Specifically, the diffuse-reflecting portion 254 is formed on a facing surface of the circuit board 100 to refract the light emitted from the LED 120. In addition, the diffuse-reflecting portion 254 may refract the light primarily refracted by the light-collecting groove 252. In other words, the diffuse-reflecting portion 254 may increase the diffusion angle of the light by secondarily refracting the light irradiated from the LED 120 or the light refracted by the light-collecting groove 252. The diffuse-reflecting portion 254 may be formed at the same height as the opening of the light-collecting groove 252.

As shown in FIG. 3, the diffuse-reflecting portion 254 may be formed with a plurality of concave grooves 2540 to diffusely reflect the light. The concave groove 2540 may have an opening formed in a direction to face the circuit board 100. As shown in FIG. 3, the concave groove 2540 may have a section formed into a cut oval shape. In other words, the concave grooves 2540 may have a section formed into a continuous cut oval shape. The above-described oval shape has a predetermined curvature, and when necessary, the concave grooves 2540 may be formed in oval shapes having curvatures different from each other.

In addition, as shown in FIG. 4, the concave grooves 2540 may be formed in square shapes having sides coming into contact with each other. The shapes of the concave groove 2540 and the opening are not limited, and it will be understood as a polygon having sides that can come into contact with other polygons and a shape that can refract light to increase the diffusion angle.

The diffuse-reflecting portion 254 may include a first diffuse-reflecting portion 2542 and a second diffuse-reflecting portion 2544.

The first diffuse-reflecting portion 2542 may be formed in a first region T1. The first region T1 is defined as a lower side of the refractive lens 250 on the lower surface of the upper case 240. The first diffuse-reflecting portion 2542 may be formed in the same range as the lower side of the refractive lens 250 in the vertical direction. In other words, the first diffuse-reflecting portion 2542 is formed to overlap with the refractive lens 250 in the up and down direction.

The second diffuse-reflecting portion 2544 extends continuously from the first diffuse-reflecting portion 2542. The second diffuse-reflecting portion 2544 may have the same structure and perform the same function as the first diffuse-reflecting portion 2542. The second diffuse-reflecting portion 2544 may be formed in a second region T2. The second region T2 is defined as a region excluding the lower side of the refractive lens 250 on the lower surface of the upper case 240. In other words, the second diffuse-reflecting portion 2544 is formed so as not to overlap with the refractive lens 250 in the up and down direction.
As described above, when the end of the light-collecting groove 252 and the diffuse-reflecting portion 254 come into contact with the circuit board 100, a space for accommodating the substrate member 140 disposed on the same surface as the LED 120 may not be formed. Accordingly, as shown in FIGS. 3 and 4, the lower side of the upper case 240 may have an accommodation groove 242 in which the substrate member 140 is positioned.

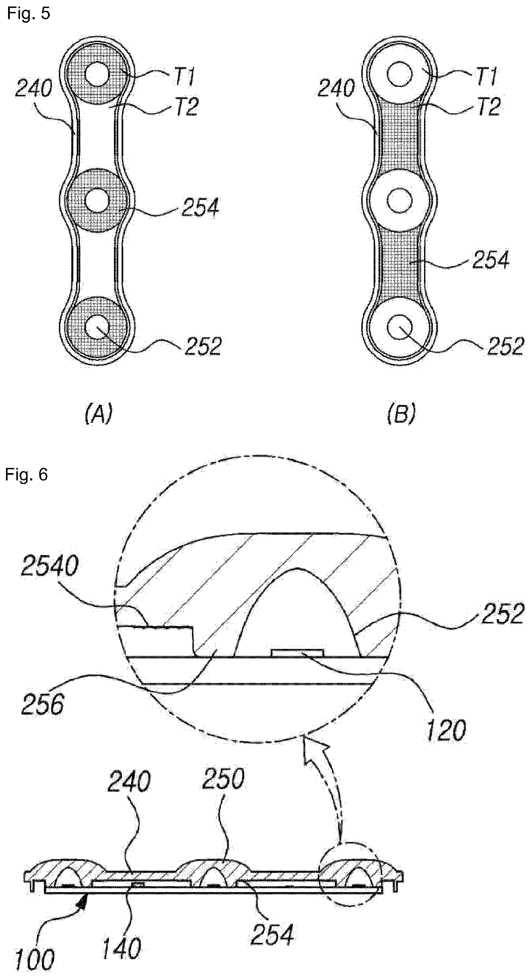

In the above-described embodiment, the diffuse-reflecting portion 254 has been described as being formed in both the first region T1 and the second region T2. However, according to another embodiment of the present invention, as shown in FIG. 5, the diffuse-reflecting portion 254 may be formed in only one of the first region T1 and the second region T2.

In addition, in the above-described embodiment, the diffuse-reflecting portion 254 has been described as coming into contact with the circuit board 100, however, a distance between the LED 120 and the diffuse-reflecting portion 254 may be adjusted, thereby adjusting a position of light reaching the side or rear of the lower case 220.

Hereinafter, an ultra wide angle LED module 10 according to another embodiment of the present invention will be described. Configurations the same as the configurations described in the ultra wide angle LED module 10 according to another embodiment of the present invention will be omitted.

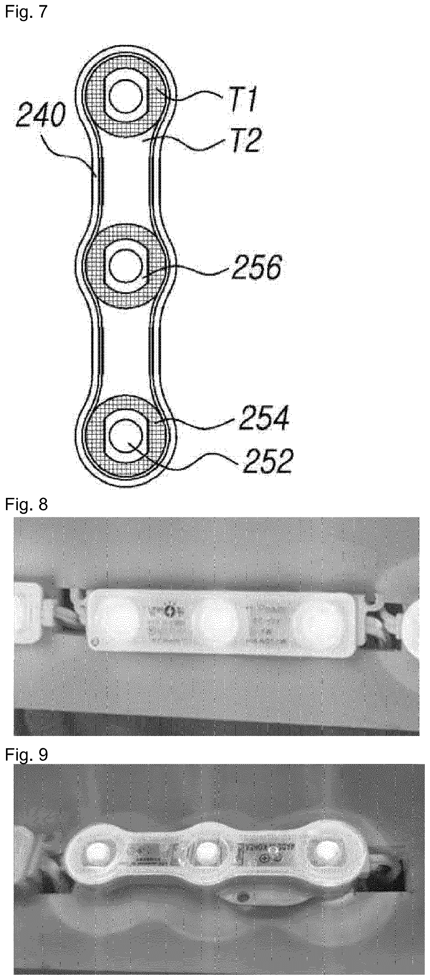

FIG. 6 is a sectional view of an upper case and a circuit board included in the ultra wide angle LED module according to another embodiment of the present invention; and FIG. 7 is a bottom view of the upper case shown in FIG. 6.

Referring to FIGS. 6 to 7, the upper case 240 may include a protrusion 256 for separating the reflective portion 254 from the circuit board 100. Accordingly, the diffuse-reflecting portion 254 may be spaced apart from the circuit board 100 by a predetermined distance or more. The protrusion 256 may be formed on the lower side of the refractive lens 250 in the upper case 240. Specifically, the protrusion 256 may extend from the refractive lens 250.

The protrusion 256 may have a cylindrical shape formed with a hollow. The hollow may be positioned to communicate with the light-collecting groove 252. The hollow may have a shape corresponding to the opening of the light-collecting groove. The protrusion 256 may be formed of the same material as the upper case 240 or the refractive lens 250. The protrusion 256 may be formed integrally with the upper case 240 or the refractive lens 250.

A part of the lower surface of the upper case 240 and the circuit board 100 are spaced apart by the protrusion 256 to form a space in which the substrate member 140 is disposed, so that the upper case 240 may disposed therein with the substrate member 140 without forming a separate accommodation groove 242. A diffuse-reflecting portion 254 may not be formed on a contact surface between the protrusion 256 and the circuit board 100.

As shown in FIG. 8, a general LED module has a structure in which a transparent case or a convex lens is provided in front of an LED, an diffusion angle of light irradiated from the LED is configured to be generally 125 degrees and up to 180 degrees, and thus the light cannot reach a rear of the LED module.

According to one embodiment of the present invention, as shown in FIG. 9, the light-collecting groove 252 refracts the light irradiated from the LED 120 to collect the light of the LED module 10, and the concave groove 2540 of the diffuse-reflecting portion 254 secondarily refracts the light irradiated from the LED 120 and the light refracted by the light-collecting groove 252 to have a diffusion angle of 200 to 240 degrees, thereby allowing the light emitted from the LED to reach the front and even the sides and the rear of the ultra-wide LED module, so that luminous efficiency can be improve.

Although it has been described that all components constituting the embodiment of the present invention are combined as one or operated in combination, the present invention is not necessarily limited to the above embodiment. In other words, one or more of all of the components may be selectively combined and operated within the scope of the present invention. Further, the terms, such as "include", "comprise" or "having" described above, signify that the corresponding component may be present therein unless specifically stated otherwise, so the above terms do not exclude other components, but may further include the other components. All terms including technical or scientific terms, unless otherwise defined, have the same meaning as generally understood by a person having ordinary skill in the art. Generally used terms, such as those defined in dictionaries, will be interpreted as consistent with the contextual meaning of the related art, and will not be interpreted as an ideal or excessively formal meaning unless expressly defined in the present invention.

In addition, the above descriptions are merely illustrative of the technical idea of the present invention, and it will be apparent that a person having ordinary skill in the art may carry out various deformations and modifications within the scope without departing from inherent features of the present invention. Therefore, the embodiments disclosed in the present invention are intended to not limit but illustrate the technical idea of the present invention, so the scope of the technical idea of the present invention is not limited by those embodiments. The scope of the present invention should be understood according to the following claims, and all technical ideas within the scope of equivalents should be construed as falling within the scope of the present invention.

## Claims

1. An ultra wide angle LED module comprising:
a circuit board including at least one LED;
a lower case having an upper side opened to be installed therein with a circuit board; and
an upper case coupled to the upper side of the lower case and having a refractive lens for refracting light emitted from the LED, wherein
the refractive lens includes:
a light-collecting groove for accommodating the LED inside to refract the light primarily emitted from the LED; and
a first diffuse-reflecting portion formed on a surface opposite to the circuit board to have a plurality of concave grooves to secondarily refract the light emitted from the LED, and
the first diffuse-reflecting portion is positioned to contact the circuit board.

2. The ultra wide angle LED module of claim 1, wherein the upper case has an accommodation groove formed on a surface facing the circuit board to allow substrate members arranged on the circuit board to be positioned therein.

3. The ultra wide angle LED module of claim 1, wherein the concave grooves have openings formed in a rectangular shape, respectively, and are arranged to have side surfaces coming into contact with each other.

4. The ultra wide angle LED module of claim 1, wherein the upper case has a lower surface formed with a second diffuse-reflecting portion having a plurality of concave grooves to refract the light emitted from the LED.

5. The ultra wide angle LED module of claim 4, wherein the second diffuse-reflecting portion extends continuously from the first diffuse-reflecting portion.

6. An ultra wide angle LED module comprising:
a circuit board including at least one LED;
a lower case having an upper side opened to be installed therein with a circuit board; and
an upper case coupled to the upper side of the lower case and having a refractive lens for refracting light emitted from the LED, wherein
the refractive lens includes:
a light-collecting groove for accommodating the LED inside to refract the light primarily emitted from the LED; and
a first diffuse-reflecting portion formed on a surface opposite to the circuit board to have a plurality of concave grooves to secondarily refract the light emitted from the LED, and
the first diffuse-reflecting portion is arranged to be spaced apart from the circuit board by a predetermined distance or more.

7. The ultra wide angle LED module of claim 6, wherein the refractive lens further includes:
a protrusion formed in a direction of the circuit board to separate the distance between the first diffuse-reflecting portion and the circuit board.

8. The ultra wide angle LED module of claim 7, wherein the protrusion is formed therein with a hollow to communicate with the light-collecting groove and accommodate the LED inside.

9. The ultra wide angle LED module of claim 6, wherein the concave grooves have openings formed in a rectangular shape, respectively, and are arranged to have side surfaces coming into contact with each other.

10. The ultra wide angle LED module of claim 6, wherein the upper case has a lower surface formed with a second diffuse-reflecting portion having a plurality of concave grooves to refract the light emitted from the LED.

11. The ultra wide angle LED module of claim 10, wherein the second diffuse-reflecting portion extends continuously from the first diffuse-reflecting portion.
